# EUROPEAN PATENT APPLICATION

(11) **EP 0 790 645 A2**
(43) Date of publication of application: **20.08.1997**
(21) Application number: 96115941.5
(22) Date of filing: 04.10.1996
(51) Int. Cl.: H01L 21/768, H01L 21/316

(54) **Intermetal dielectric planarization**

(30) Priority: 03.10.1995 US 4705
(71) Applicant: TEXAS INSTRUMENTS INCORPORATED, Dallas Texas 75265 (US)
(72) Inventor: Marsden, Mary H., Dallas, TX 75243 (US); Erz, Karen G., Frisco, TX 75035 (US); Ahlburn, Byron T., Plano, TX 75023 (US)
(74) Representative: Schwepfinger, Karl-Heinz, Dipl.-Ing.

(57) **Abstract**

A process is provided for implementing inter-metal dielectric ("ILD") planarization using hydrogen silsesquioxane ("HSQ") spin-on glass ("SOG") and conformal plasma enhanced tetraethyloxysilane ("PETEOS") for submicron gaps, such as vias and interconnects, having sputtered metal interconnects. The invention is particularly suitable for use in submicron CMOS and BiCMOS, processes, such as those related to the manufacture of digital signal processors, memory, logic circuits, application specific and other process that use a minimum of double-layer metallization.

## Description

### FIELD OF THE INVENTION

This invention relates to a process for forming a planar intermetal dielectric layer for submicron apertures.

### BACKGROUND OF THE INVENTION

As geometries in semiconductor circuits have shrunk to and below 0.5 microns, demands upon the inter-level dielectric (ILD) films for the interconnect patterns in the semiconductor circuits have become increasingly stringent. Future contemplated ILD films will be called upon to fill gaps with higher aspect ratios and provide lower dielectric constants than are required of the ILD films currently in use. Reduction of the dielectric constant for the film is desirable, as such a reduction results in a reduction in both inter-level and intra-level capacitance, both of which retard the operational speed of circuits processed with oxides presently used for electrical isolation. It is well known that this retarding effect becomes progressively more severe as the circuit complexity increases.

Moreover, as the circuitry of integrated circuit devices becomes more complex and more dense, the number of layers of metallurgy must also increase. With this increase in number of metallurgy layers, the surface planarity of each successive layer becomes more non-planar due to associated interlayer layers following the contour of underlying metallurgy stripes and supporting layers. With each successive layer, there exists a greater number of metallurgy layers to contribute to the irregularity of the surface. As such, structures having two or more levels can develop severe non-polar topographies, and may face severe reliability problems as the result of poor metal step-coverage and poor microlithographic delineation processes. A potential solution to overcome these problems is a planarization process of the dielectric interlayers.

Both inorganic and organic layers deposited by spin-on-glass ("SOG") techniques have been widely used for microminiaturized multilevel interconnection circuitry. The deposited dielectric layers have conventionally been subjected to an etch-back process which further smoothens the surface. However, this layer etch-back steps adds an extra step in the process for each layer deposited which, in turn, results in added cost and the potential for reducing product yield. While inorganic SOG can be planarized by heating, thereby allowing for avoidance of the foregoing etch-back step, other process-oriented problems can arise which compromise the objective of ILD planarization. For example, when ILD layers are subjected to O₂ plasma incident to the removal of photoresist that is used incident to via formation, H₂O can be absorbed into the layer, which is deleterious to the associated metallurgy. Moreover, when organic SOG is exposed while in vias, it contains outgassed moisture or other substances that cause high resistances to be encountered in the vias when electrically conductive metals are sputtered into the vias. This problem is known as "via poisoning" and arises when methylsiloxane-based spun on glass is used for gap fill and planarization of integrated circuits with multiple levels of metal interconnect. The quality of chemical vapor deposited (CVD) tungsten deposition in vias which have such organic SOG exposed in the via sidewalls is severely compromised, often resulting in incompletely filled vias, vias with high resistance and metal growth (hillocks) from the tops of vias that cause short circuits with other metal lines. It is believed that the organic portion of the organic SOG reacts in some adverse way with the tungsten source materials. A discussion of further difficulties encountered with the deposition of insulating semiconductor interlayers can be found in specification and cited references of U.S. Patent No. 5,413,963.

One common solution to the problem of via poisoning is to perform a partial plasma etch-back of the SOG, leaving the SOG only between, or along, the sides of metal leads. This solution requires that semi-organic glass be deposited over the entire wafer with etch back in a plasma etcher. This procedure is very slow, very dirty, leaves particles on the wafer and is not uniform. Other approaches use thinner coats of SOG, such as by moving the vias to locations where the SOG layer is thinner or in conjunction with careful cure, etch, via bake and metal deposition procedures, with varying degrees of success.

ILD structure decisions are commonly driven by defect levels, process complexity, electrical performance, and planarization capabilities. The foregoing categories are all areas in which flowable oxides have shown promise. The flowable nature of flowable oxide materials is attractive, for it can simplify ILD processing and is capable of providing exceptional gap fill and planarization performance. Superior planarization has been demonstrated for flowable oxide-based ILD processes integrated in 0.7 µm technology as compared to plasma enhanced tetraethyloxysilane ("PETEOS") oxide deposition and/or etch processes. However, the high wet etch rate of HSQ complicates via etching, and the desired "champagne glass" slope of via sidewalls cannot be formed solely from a wet etch process. Instead, other process steps are required, which contributes to the expense, complexity and time associated with device manufacture.

### SUMMARY OF THE INVENTION

A process is provided for implementing inter-metal dielectric ("ILD") planarization using hydrogen silsesquioxane ("HSQ") spin-on glass ("SOG") and conformal plasma enhanced tetraethyloxysilane ("PETEOS") for submicron gaps, such as vias and interconnects, having sputtered metal interconnects. The invention is particularly suitable for use in submicron CMOS and BiCMOS, processes, such as those related to the manufacture of digital signal processors, memory, logic circuits, application specific and other processes that use a minimum of double-layer metallization.

Accordingly the present invention provides a method of forming a planar dielectric layer over an interconnect pattern comprising the steps of providing a substrate having an electrical interconnect pattern thereon, forming a first layer of dielectric over said interconnect pattern, forming a second layer of silicon-containing dielectric over said first dielectric layer from an inorganic silicon-containing composition and forming a third layer of dielectric different form said second layer over said second dielectric layer.

According to a second aspect of the present invention there is provided A multilevel interconnect pattern comprising, a substrate having an electrical interconnect pattern thereon, a first layer of dielectric over said interconnect pattern, a second layer of silicon-containing dielectric over said first dielectric layer formed from an inorganic silicon-containing composition capable of forming silicon oxide, a third layer of dielectric different from said second layer over said second dielectric layer and an electrical interconnect pattern disposed over said third layer.

### BRIEF DESCRIPTION OF THE DRAWINGS

The present invention will now be further described by way of example with reference to the accompanying drawings in which:-
FIGURES 1A to 1G depict a process flow for a prior art procedure for providing a planarized dielectric layer over an interconnect pattern for a DRAM;
FIGURES 2A to 2I depict a process flow for a prior art procedure for providing a planarized dielectric layer over an interconnect pattern for a logic circuit;
FIGURES 3A to 3N depict a tri-layer metal process flow in accordance with the present invention which can be used for both DRAM and logic circuit fabrication; and
FIGURES 4A to 4C depict a bi-layer metal process flow in accordance with the present invention which can be used for both DRAM and logic circuit fabrication.

### DETAILED DESCRIPTION OF THE PREFERRED EMBODIMENTS

It is to be understood and appreciated that the process steps and structures described below do not form a complete process flow for the manufacture of integrated circuits. The present invention can be practiced in conjunction with integrated circuit fabrication techniques that are currently used in the art, and only so much of the commonly practiced process steps are included herein as are necessary to provide an understanding of the present invention. The drawing figures that are included with this specification and which represent cross-sections of portions of an integrated circuit during fabrication are not drawn to scale, but instead are drawn so as to illustrate the relevant features of the invention.

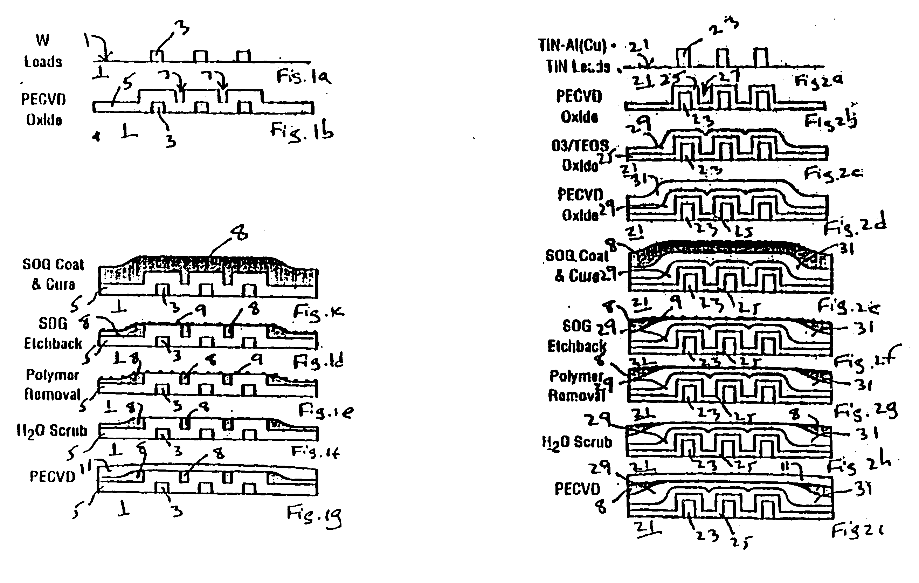

Referring first to FIGS. 1A to 1G, there is shown a process flow for a prior art procedure for providing a planarized dielectric layer over an interconnect pattern for a DRAM. Initially, the interconnect pattern 3 is formed on a substrate 1 by deposition of the interconnect metal, such as tungsten, with subsequent patterning and etching as shown in FIG. 1A. A 7,000Å layer of plasma TEOS oxide 5 is then deposited over the exposed surface, leaving indentations or valleys 7 in the region between portions of the interconnect pattern as shown in FIG. 1B. A 6,200Å to 6,400Å layer of organic SOG 8 is then deposited over the structure of FIG. 1B and cured as shown in FIG. 1C or etched back and then cured. The structure of FIG. 1C is then etched back if not previously etched back until the TEOS oxide 5 is exposed as shown in FIG. 1D and then any polymers 9 collected on the structure are removed by an oxygen plasma treatment as shown in FIG. 1E. Any remaining polymer and dirt is then removed from the surface with a water scrub as shown in FIG. 1F. The structure is then baked at a temperature of 410°C for about 2 1/2 minutes and a 5,000Å layer of TEOS oxide 11 is then deposited over the surface as shown in FIG. 1G to provide the planarized surface.

Referring now to FIGS. 2A to 2I, there is shown the process flow for a prior art procedure for providing a planarized dielectric layer over an interconnect pattern for a logic circuit. Initially, the interconnect pattern 23 is formed on a substrate 21 by deposition of the interconnect metal, such as aluminum, with subsequent patterning and etching as shown in FIG. 2A. Since aluminum can form hillocks which can cause short circuits with overlying interconnect layers, it is necessary to provide a thicker dielectric layer than is required in the DRAM embodiment. Therefore, a 3,000Å layer of plasma TEOS oxide 25 is deposited over the exposed surface, leaving indentations or valleys 27 in the region between portions of the interconnect pattern as shown in FIG. 2B. This is followed by a nitrogen plasma treatment which is then followed by a 3,000Å layer of ozone TEOS oxide 29 as shown in FIG. 2C and then by a 4,000Å layer of plasma TEOS oxide 31 as shown in FIG. 2D. The procedure is then the same as explained hereinabove for the DRAM with reference to FIGS. 1C to 1G, which correspond to FIGS. 2E to 2I, respectively.

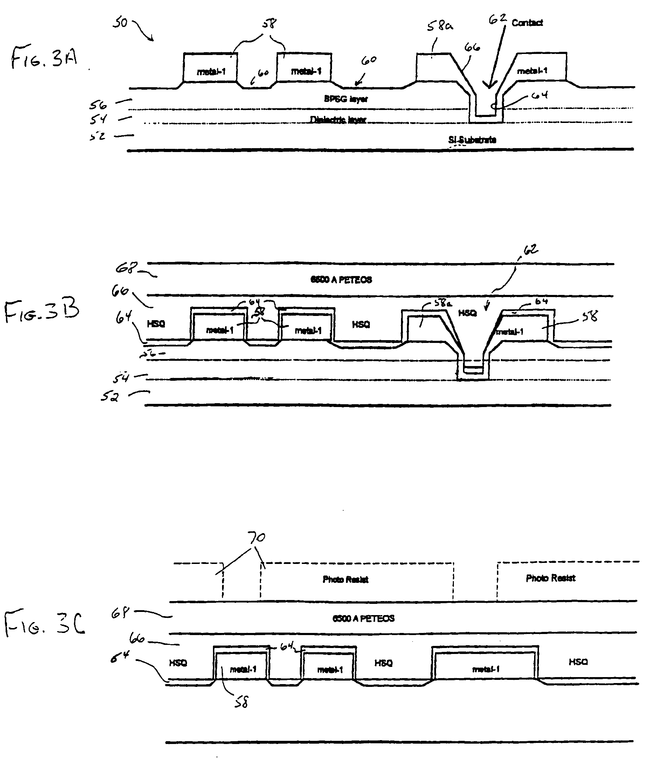

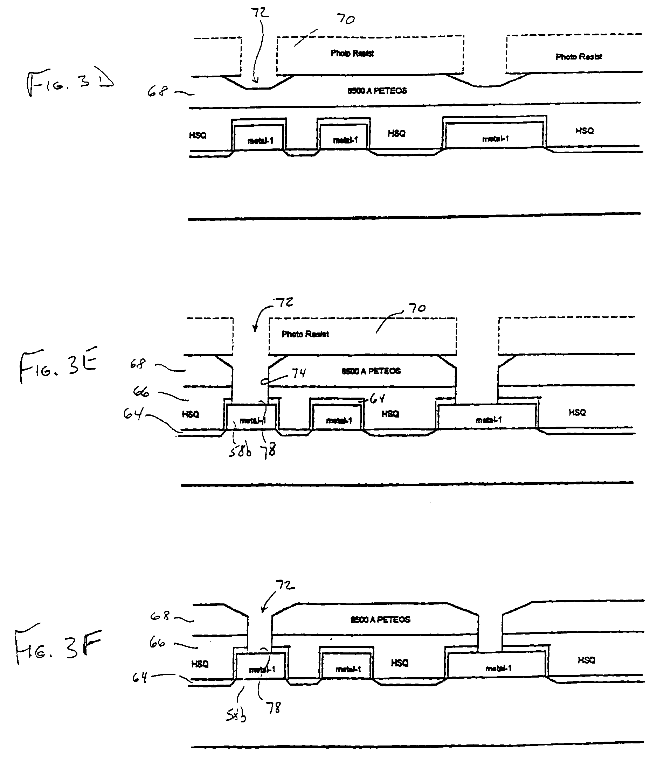

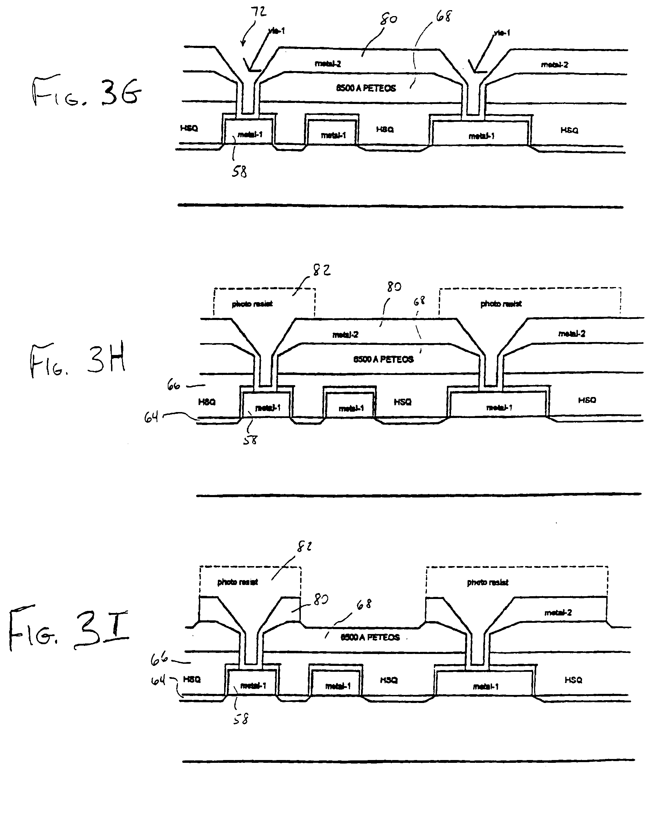

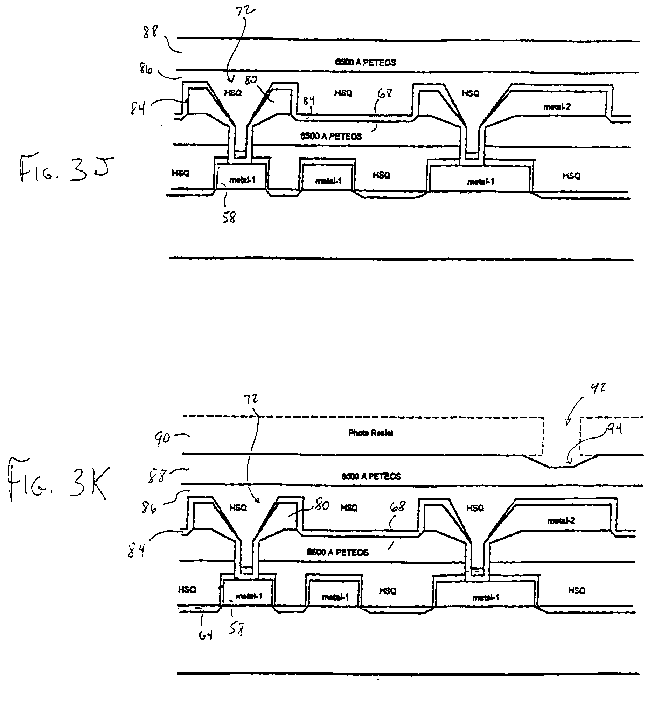

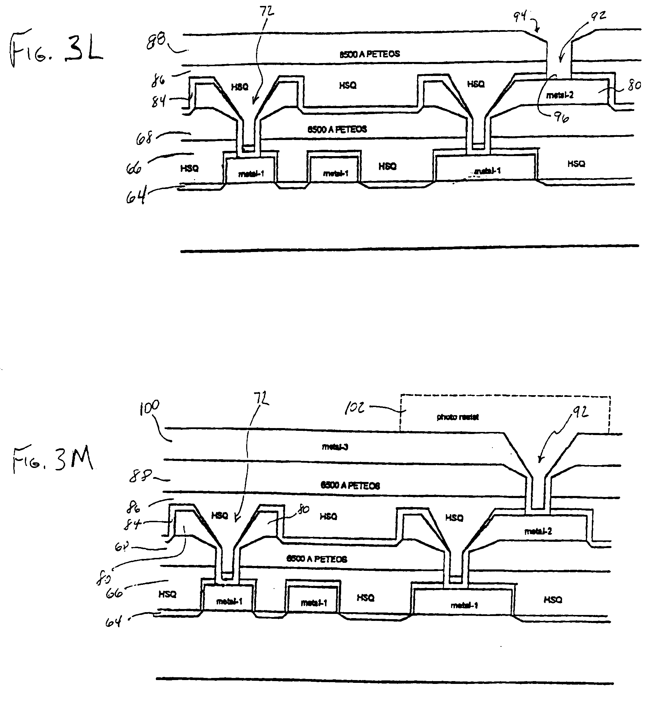

Details of the invention in connection with a triple layer metal process are illustrated in FIGS. 3A - 3N. With particular reference to FIG. 3A, there is illustrated a portion 50 of a semiconductor device under construction. At this stage of construction, the portion 50 is comprised of a Silicon substrate 52 that underlies a dielectric layer 54. The dielectric layer 52 can be comprised of a tri-level sandwich of an underlying ∼6,200Å thermal oxide which underlies an ∼7,500Å plasma enhanced tetraethyloxysilane ("PETEOS"). Sandwiched between the thermal oxide and the PETEOS is an ∼300Å silane oxide layer provided to reduce implant channeling, thus rendering a total dielectric layer thickness of about 14,100Å. A further dielectric layer, in the form of a Boro-Phospho-Silicate Glass ("BPSG") layer 56, is deposited and densified in a conventional manner, as by processing in a Watkins-Johnson reactor with N₂. The composition of the BPSG can be as follows: Boron 2.4-3.2 wt.%; Phosphorus 5.9-6.25 wt.%; and balance Silicon, although other BPSG compositions are contemplated for use in the present invention. The HSQ layer 66 is applied to a thickness of about 5,700Å, preferably while the silicon wafer is rotating at a speed of about 500 RPM. The layer 66 can be thinned-out by rotating at higher speeds, such as 2,500 RPM.

A metal stack 58, designated as "Metal-1", is deposited *in situ* over the BPSG layer. In a preferred aspect of the invention, the Metal-1 stack is comprised of a vertical array of three sputtered metals: an underlying 500Å layer of Titanium that is deposited adjacent to the BPSG layer 56; an overlying 3,000Å layer of Ti(10%)-W; and an uppermost ∼4,600Å layer of Al-Si (1%) - Cu (0.5%). Thus, the total thickness of the Metal-1 stack is about 8,100Å. Following stack deposition, it is patterned using conventional photolithographic techniques and etched. Etching removes about 2,000Å of the BPSG layer 56 incident to a metal "over-etch", indicated by the recesses 60 in the drawing. The over-etch can create an effective metal stack height of in excess of ∼10,000Å, which will be planarized with dielectrics in subsequent process steps, as will be described in detail below. A contact 62 extends through one of the metal stacks, designated 58a, and through the BPSG and dielectric layers 56 & 54, respectively. The inner surface 64 of the contact 62 is lined with metal from the tri-layer metal stack 58, as is shown in the drawing. The upper surfaces 66 of the contact are constructed along divergent planes to establish a desired "champagne glass" or "martini glass" contour which is preferred to facilitate contact filling in the manner set forth below. The contact 62 can be formed by any of a variety of suitable process, including an initial wet etch, followed by dry etch which, in turn, is followed by a reduced-power soft etch.

As is depicted in FIG. 3B, a 1,000Å layer of conformal plasma enhanced TEOS oxide 64 is deposited over the structure 50. Thereafter, an approximately ∼5,700Å layer 66 of hydrogen Silsesquioxane ("HSQ") is spun-on and baked. It is to be appreciated that reference to the HSQ thickness pertains to the thickness of the HSQ that is obtained when the material is spun-on a bare silicon wafer under standard processing conditions. It is to be appreciated that the thickness of the HSQ on a patterned wafer is a function of local wafer topography. For example, the thickness will be greater than the above-referenced 5,700Å between closely-spaced metal lines, and will correspondingly thin-out in open areas. The overall effect is a high degree of topography smoothing and short range planarization, as very little HSQ remains over narrow, isolated leads, while the thickness over wide leads or closely spaced, narrow leads can be expected to be a considerable fraction of the above-referenced thickness.

The HSQ film 66 is cured in an atmospheric furnace at about 400°C with a nitrogen ambient. Following thermal processing, the wafer carrying the device 50 is inserted into an PETEOS CVD chamber (not shown) and, prior to deposition of subsequent layers, the wafer is baked at about ∼380°C at ∼ 8 Torr for about 60 seconds in a nitrogen ambient. Following nitrogen thermal processing, an ∼6500Å layer 68 of PETEOS is deposited. Deposition of PETEOS is advantageous, as it is conformal and can be deposited at a relatively low temperature (<400°C) so as to minimize granule formation in the associated metal stacks.

With reference to FIGS. 3C & 3D, the wafer 50 is patterned using conventional photolithography techniques to define the location of the vias and/or locations where metal-1 stack 58 will need to form an ohmic contact with a subsequently-applied metal-2 stack. This patterning is illustrated by shadow boxes 70 in FIG. 3C. The contact 62 appearing in FIGS. 3A & 3B has been omitted from FIG. 3C and subsequent drawings for the purpose of simplification and clarity.

Following photoresist patterning, the wafer 50 is baked to harden the photoresist. Thereafter, the photoresist 70 is etched in an aqueous buffered oxide etch solution comprising 6.5% HF and 35% NH₄F with Olin Hunt surfactant and COE with DHS. A result of this etching is an isotropic etch profile that removes approximately ∼3000-5000Å of the upper PETEOS layer 68. Processing conditions are controlled to ensure that etching does not eradicate all of the PETEOS layer 68 and invade the underlying HSQ layer 66, as the HSQ would be rapidly removed from the wafer in an HF solution. It is to be appreciated that etching through the PETEOS 68 and into the HSQ layer 66 would prevent adequate metal coverage of the via during subsequent metal sputtering. Etching of the PETEOS layer 68 in the foregoing manner results in the development of a well 72 that extends partially under the patterned photoresist 70.

Following formation of the well 72, the wafer 50 is then etched in a plasma reactor using CF₄/CHF₃ chemistry to remove the remaining oxide in the via 72. Plasma reactor etching results in the formation of a via having substantially straight sidewalls 74 and a desired "martini" or "champagne" glass configuration at the open end of the via. The openings of the bottom of the vias following the via etch are about 1.1µm. The foregoing plasma reactor etch also etches through approximately ∼0.85µm (8,500Å) of dielectric layers (PETEOS 68 and HSQ 66) overlying the upper surface 78 of associated metal leads such as lead 58b in FIG. 3E. Via etching in the foregoing manner yields a via aspect ratio of about 0.77.

Following formation of the vias 72 in the manner described above, the photoresist 70 is removed in a conventional manner, such as solvent clean/rinse, plasma ash, solvent/clean rinse and plasma ash, to render a structure as shown in FIG. 3F that is substantially devoid of photoresist. The last ash step has been found to be particularly effective at removing any solvents that may have been absorbed by the HSQ in the via sidewalls. Each solvent step provides cleansing in an Ashland ACT-CMI DMAC clean, followed by an IPA rinse/vapor dry. Each ash is performed in a barrel asher in an oxygen plasma atmosphere.

With reference to FIG. 3G, there is depicted application of a second metal stack 80, designated "Metal-2". Prior to application of metal-2 stack 80, the wafer receives an argon sputter etch to remove any residue and aluminum from the lower surface of the vias 72. The argon sputter etch is undertaken to remove ∼180Å ± 20Å of silane (SiH₄) oxide. In addition, wafers are subjected to a low pressure bake. The Metal-2 layer 80 is comprised of combination of ∼2,000Å Ti(10 wt.%)-W and ∼4,600Å Al-Si(wt.%)-Cu(0.5 wt.%) that are sputtered onto the wafer. As is indicated in the drawing, the sputter process partially fills the vias 72 with metal to create a path for electrical conduction between Metal-1 layer 58 and Metal-2 layer 80. However, voids or cavities remain in the vias 72 which will be filled with an oxide as will be described below. Overall metal stack height for Metal-2 layer 80 at its thickest point is approximately 6,600Å.

Once the Metal-2 stack 80 has been applied, the wafers are processed through photolithography (FIG. 3H) to define a pattern for the Metal-2 stack 80. The patterning is illustrated by shadow boxes 82 in FIG. 3H. As is shown in FIG. 3I, the etching of the Metal-2 stack 80 can remove up to about 2,000Å of PETEOS oxide while thereby rendering an effective step height of about 8,000Å that will require planarization. The photoresist 82 is then removed in a conventional manner, and a 1,000Å PETEOS layer 84 is applied over Metal-2 stack 80 and the exposed portion of PETEOS dielectric layer 68. HSQ layer 86 of approximately 5700Å is applied over the 1,000Å dielectric layer 84. In addition, a further PETEOS layer 88 of a approximately 6500Å is deposited over the HSQ layer 86 in the manner described above in connection with FIG. 3B. The 1,000Å PETEOS layer 84 deposits into the via 72, with HSQ 86 filling the remainder of the void.

Following application of the dielectric layers 84-88, the circuit 50 is patterned with photoresist incident to formation of a second via layer, as will now be described. With reference to FIG. 3K, the patterned photoresist 90 is baked and then etched in the manner described previously in connection with FIG. 3D. Etching in this manner results in the formation of second via 92 having the desired "martini" or "champagne" glass open end, as indicated by reference character 94. The wafer is then etched in a plasma reactor to complete the via etch process (FIG. 3L), thereby fully developing the via 92 so as to extend completely through PETEOS layer 88, HSQ layer 86 and underlying PETEOS layer 84 to the upper surface 96 of Metal-2 stack 80.

With reference to FIG. 3M, there is illustrated construction for a Metal-3 stack 100. The Metal-3 stack 100 is deposited in an analogous manner as that described previously in connection with Metal-2 stack 80. The Metal-3 stack 100 is comprised of ∼2,000Å Ti(10 wt.%)-W and ∼6,000Å Al-Si (1 wt. %) - Cu (0.5 wt.%)∀ and is patterned with photoresist, as indicated by phantom box 102. Following patterning and etching of Metal-3 stack 100, the photoresist 102 is removed, and a layer of passivation before is deposited, patterned and etched, thereby rendering the structure illustrated in FIG. 3N.

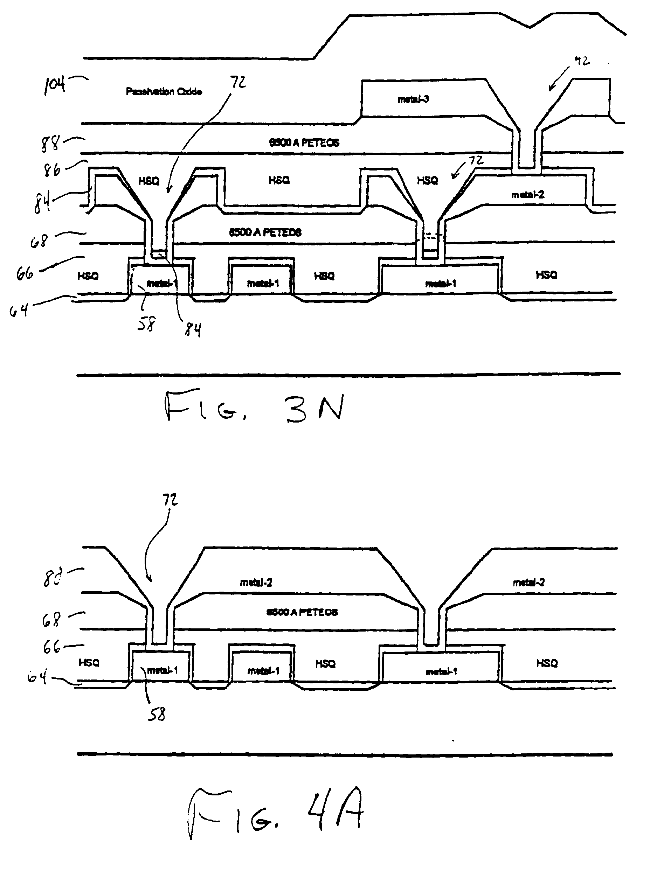

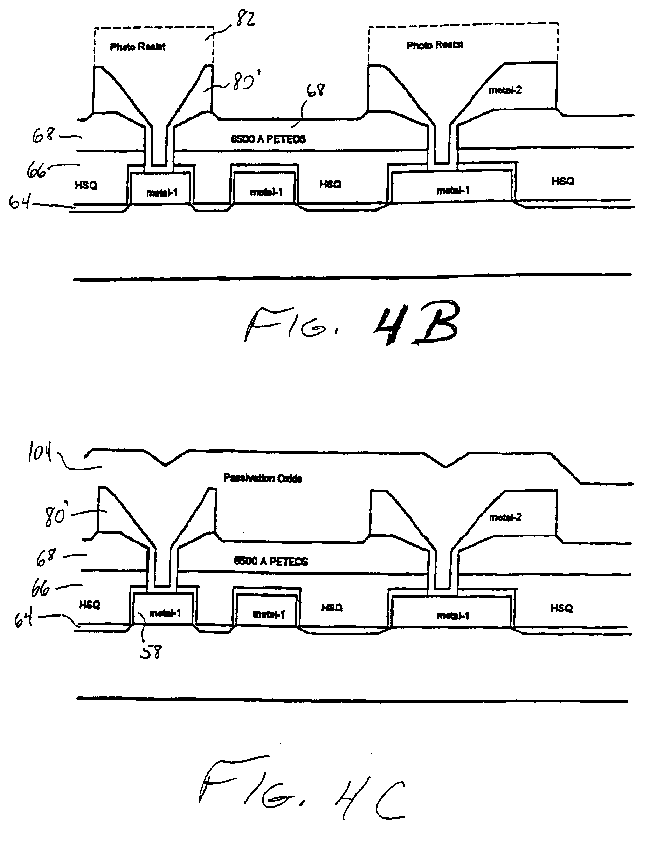

Details of a double or bi-layer metal process are illustrated in FIGS. 4A - 4C. With reference to FIG. 4A, there is illustrated a device under construction incident to double or bi-layer metal processing in a manner analogous to the stage of triple layer processing discussed above in connection with FIGS. 3A - 3F.

Prior to sputtering the second metal stack 80', the wafer is exposed to an argon sputter etch and a low pressure bake to remove aluminum and residue from the bottom of the vias 72. Metal-2 stack 80' is comprised of ∼2,000Å Ti (10 wt.%) -W and ∼6,000Å Al - Si (1 wt.%) - Cu (0.5 wt. %). As is illustrated in the drawing, the sputter process for the Metal-2 stack 80' partially fills the vias 72 with metal to create a path for electrical conduction between Metal-1 stack 58 and Metal-2 stack 80'. The Metal-2 layer 80' is patterned with photoresist 82 and etched in a manner described previously, with the metal over-etch removing about 2,000Å PETEOS (FIG. 4B). Following removal of the photoresist 82, a layer of passivation oxide 104 is deposited, patterned and etched as shown in FIG. 4C, to render a planarized surface at the Metal-2 stack level.

The advantages of the foregoing planarization processes include excellent gap-fill characteristics and local planarization. Moreover, use of HSQ through the various processes is advantageous as HSQ exhibits an advantageously low (<3.0) dielectric constant. The improved planarization that results from the foregoing processes reduces defects caused by metal stringers, resulting in an increase in yield over conventional resist etch-back ("REB") processes now in use throughout the industry. As HSQ is a non-carbon based SOG compound, it does not require an etch back. Accordingly, vias etched through HSQ are not exposed to "via poisoning" arising from carbon out-gassing, as is experienced conventional ILD processes.

Although the invention has been described with respect to a specific preferred embodiment thereof, many variations and modifications will immediately become apparent to those skilled in the art.

## Claims

1. A method of forming a planar dielectric layer over an interconnect pattern comprising the steps of:
providing a substrate having an electrical interconnect pattern thereon;
forming a first layer of dielectric over said interconnect pattern;
forming a second layer of silicon-containing dielectric over said first dielectric layer from an inorganic silicon-containing composition; and
forming a third layer of dielectric different form said second layer over said second dielectric layer.

2. The method of Claim 1, further comprising forming said first layer from a plasma generated TEOS oxide.

3. The method of Claim 1 or Claim 2, wherein step of forming said second dielectric layer comprises forming said second dielectric layer from a silicon-containing composition comprising hydrogen silsesquioxane (HSQ).

4. The method of any preceding claim, wherein said step of forming said third dielectric layer comprising forming said third dielectric layer from a plasma generated TEOS oxide.

5. The method of any preceding claim, wherein the step of forming said second layer comprises the steps of depositing an inorganic silicon-containing composition capable of being pyrolytically converted to a silicon oxide over the structure from the of depositing the second dielectric layer step and placing the resulting structure in an substantially pure nitrogen and moisture-free environment at a pressure at or below atmospheric pressure, and heating the said silicon containing composition to a temperature of substantially between 375°C to 425°C for a period substantially between 30 minutes to 90 minutes to convert said silicon-containing composition to silicon oxide.

6. The method of Claim 5, wherein said heating step comprises heating said silicon-containing composition to a temperature substantially of 400°C for about 45 minutes.

7. The method of any preceding claim, wherein the step of forming the said third layer comprises the steps of placing the structure from the step of forming the third layer in a vacuum chamber and heating in a nitrogen ambient at a pressure substantially of 3 Torr to 15 Torr at a temperature substantially of from 350°C to 430°C for a period substantially between 30 seconds and 90 seconds, and depositing a layer of plasma generated TEOS oxide with a thickness of substantially between 2000Å to 4000Å over said structure.

8. The method of Claim 7, wherein said heating step comprises heating said structure to a temperature substantially of 390°C for 60 seconds.

9. The method of Claim 7, further comprising maintaining said pressure of about 9 Torr.

10. The method of Claims 7 to 9, further comprising forming said third dielectric layer to thickness of about 3000Å.

11. A multilevel interconnect pattern comprising:
a substrate having an electrical interconnect pattern thereon;
a first layer of dielectric over said interconnect pattern;
a second layer of silicon-containing dielectric different over said first dielectric layer formed from an inorganic silicon-containing composition capable of forming silicon oxide;
a third layer of dielectric different from said second layer over said second dielectric layer; and
an electrical interconnect pattern disposed over said third layer.

12. The pattern of Claim 11, wherein said silicon-containing composition is Hydrogen Silsequioxane (HSQ).

13. The pattern of Claim 11 or Claim 12, wherein said second layer has a dielectric constant less than about 4.0.
